# EUROPEAN PATENT APPLICATION

(11) **EP 4 471 853 A1**
(43) Date of publication of application: **04.12.2024**
(21) Application number: 23176416.8
(22) Date of filing: 31.05.2023
(51) Int. Cl.: H01L 23/495

(54) **DIE PADDLE**

(71) Applicant: Nexperia B.V., 6534 AB Nijmegen (NL)
(72) Inventor: Yandoc, Ricardo, Manchester (GB); Dimaano Jr, Antonio B., Singapore (SG); Brown, Adam, Manchester (GB); Garbin, Giovanni, Cabuyao (PH); Malveda, Homer, Cabuyao (PH)
(74) Representative: Pjanovic, Ilija

(57) **Abstract**

A die paddle for a semiconductor assembly is disclosed. The die paddle comprises first and second major faces, a coined region and at least one aperture. The first and second major faces are offset from another by a thickness of the die paddle, and are at least partly defined by an outer perimeter of the die paddle. The coined region is recessed into at least one of the first and second major faces, the coined region extending from, and at least partway around, the outer perimeter of the die paddle. The at least one aperture, which extends through the coined region, is for receipt of material therein. The at least one aperture is disposed adjacent, and is at least partially surrounded by, an internal corner of the die paddle. The internal corner is at least partly defined by the coined region.

## Description

The present invention relates to a die paddle for a semiconductor assembly, a semiconductor assembly, and a method of manufacturing the semiconductor assembly.

Semiconductor assemblies, such as transistors, are manufactured as layered assemblies including components such as die paddles, dies, clips and a casing. The casing provides a protective functionality and (at least partly) surrounds the die and other components forming part of the semiconductor assembly. The casing may otherwise be referred to as an encapsulant.

In use, semiconductor assemblies are subjected to many cycles of thermal fatigue in which the various components forming the semiconductor assembly increase, and subsequently decrease, in temperature. Accordingly, thermal expansion of the components forming part of the semiconductor assembly occurs in use. It has been observed that, in use, the casing of a semiconductor assembly may delaminate (e.g. separate from) other components of the semiconductor assembly, such as the die paddle, which risks damage to the semiconductor assembly. Similarly, cracking and other discontinuities have been observed in the casing.

There exists a need to overcome one or more of the disadvantages associated with existing semiconductor assemblies, whether mentioned in this document or otherwise.

According to a first aspect of the invention there is provided a die paddle for a semiconductor assembly, comprising:
first and second major faces offset from another by a thickness of the die paddle, and being at least partly defined by an outer perimeter of the die paddle;
a coined region recessed into at least one of the first and second major faces, the coined region extending from, and at least partway around, the outer perimeter of the die paddle; and
at least one aperture, which extends through the coined region, for receipt of material therein; wherein
the at least one aperture is disposed adjacent, and at least partially surrounded by, an internal corner of the die paddle, the internal corner being at least partly defined by the coined region.

The die paddle may otherwise be described as a plate of conductive material. The die paddle may be manufactured from a copper alloy or entirely from copper.

The coined region may otherwise be described as a region of reduced thickness, or a recessed region. The coined region may be formed by a process such as etching or stamping.

The internal corner of the die paddle may otherwise be described as a shoulder of the die paddle.

The aperture being disposed adjacent the internal corner may otherwise be defined as a proximate edge of the aperture being provided within one major dimension, of the aperture, of the internal corner.

The at least one aperture may be created by one or more of a laser, etching or stamping process.

The at least one aperture may be described as being configured to receive material therein, or therethrough.

Advantageously, the at least one aperture provides a robust mechanical locking between a casing and the die paddle, and reduces the risk of delamination or cracking occurring. Delamination and cracking undesirably increase the risk that contaminants, such as moisture, penetrate the casing into the parting line between the casing and lead frame/die paddle.

Advantageously, the incorporation of the aperture does not alter the exposed outer geometry of the die paddle. Further advantageously, the at least one aperture allows the moulded casing to extend through the die paddle for improved material flow at the point of moulding the casing, and more robust adhesion of the casing to the die paddle.

The at least one aperture may be a circular bore.

The circular bore advantageously provides an aperture which is readily manufactured. Furthermore, the circular bore generally does not introduce any stress raisers in the die paddle.

The at least one aperture may comprise a plurality of apertures.

The plurality of apertures may comprise two or four or a different number of apertures. All apertures may share a common geometry, or the apertures may have different geometries. The apertures may be arranged in a substantially symmetrical layout such that the die paddle has at least one plane of symmetry.

The inventor has identified that providing a plurality of apertures has been found to improve the robustness of the coupling of the casing to the die paddle.

The at least one aperture may be disposed proximate the outer perimeter of the die paddle.

The outer perimeter of the die paddle may be defined by a plurality of sides.

The outer perimeter of the die paddle maybe defined by four sides. The die paddle may thus be described as generally quadrangular.

The coined region may extend only partway along two of the plurality of sides.

The coined region extending only part way along two of the plurality of sides advantageously provides a convenient mounting position for tie bars of the casing.

The coined region extending only part way along two of the plurality of sides has been found to provide desirable locking capability, of the casing to the die paddle, whilst maintaining footprint compatibility with standard semiconductor assembly packaging.

Further advantageously, the non-coined region of the two of the plurality of sides provides a convenient location where the die paddle can be connected to the surrounding leadframe (i.e. held) during the manufacturing process.

In other embodiments, the coined region may extend along an entirety of three sides of the die paddle.

First and second portions of the coined region, disposed along each of the two of the plurality of sides, may at least partly define a respective internal corner.

An aperture may be disposed adjacent each of the two internal corners defined by the first and second portions of the coined region.

A third portion of the coined region may extend along an entirety of at least one of the plurality of sides.

The third portion of the coined region may interpose the first and second portions of the coined region.

The third portion of the coined region interposing the first and second portions of the coined region advantageously means the coined region can be defined by a collection of continuous portions. The coined region thus extends around more of the outer perimeter of the die paddle, which means the coupling of the casing to the die paddle is improved.

The at least one aperture may have a substantially uniform cross-section.

The die paddle may further comprise at least one aperture, disposed proximate an external corner of the die paddle, in the coined region.

Providing an aperture proximate external corners of the die paddle in the coined region has been found to advantageously improve the adhesion of the casing to the die paddle. The aperture provided proximate the external corner of the die paddle may be the same aperture which is provided proximate the internal corner, or maybe a different aperture (e.g. such that the die paddle comprises two or more apertures).

An aperture may be disposed proximate each of a respective two external corners.

Providing an aperture proximate each of respective two external corners, in the coined region, advantageously improves the adhesion of the casing to the die paddle. Furthermore, the apertures maybe provided in a substantially symmetric arrangement so as to provide a more even distribution coupling strength across the die paddle.

An aperture being provided proximate each of a respective two external corners may otherwise be described as one aperture being provided proximate a first external corner, and another aperture being provided proximate a second external corner.

The apertures disposed proximate each of the respective two external corners may be disposed proximate ends of the third portion of the coined region.

Advantageously, providing apertures proximate each of the two external corners, proximate ends of the third portion of the coined region, provides a distribution of apertures across the surface of the die paddle.

The internal and/or external corner may be filleted, and the adjacent aperture may be concentric with the internal and/or external corner.

Any of the corners described throughout this document may be fileted. Where the internal corner is filleted, the, for example, circular aperture may be concentric with the filleted internal corner. This may mean that the aperture is collinear with internal corner insofar as they share an edge, or may mean that the aperture is concentric with, but offset from, the internal corner (e.g. there is no collinearity). Similarly, where the external corner is filleted, the adjacent aperture provided proximate the external corner maybe concentric with the external corner or offset therefrom.

According to a second aspect of the invention there is provided a die paddle for a semiconductor assembly, comprising:
first and second major faces offset from another by a thickness of the die paddle, and being at least partly defined by an outer perimeter of the die paddle;
a coined region recessed into at least one of the first and second major faces, the coined region extending from, and at least partway around, the outer perimeter of the die paddle; and
at least one aperture, which extends through the coined region, for receipt of material therein; wherein
the at least one aperture is disposed adjacent an external corner of the die paddle.

The die paddle may otherwise be described as a plate of conductive material. The die paddle may be manufactured from copper.

The coined region may otherwise be described as a region of reduced thickness, or a recessed region. The coined region may be formed by a process such as etching.

The external corner of the die paddle may be filleted.

The aperture being disposed adjacent the external corner may otherwise be defined as a proximate edge of the aperture being provided within two major dimensions, of the aperture, of the external corner.

The at least one aperture may be created by one or more of a laser, etching or stamping process.

Advantageously, the at least one aperture provides a robust mechanical locking between a casing and the die paddle, and reduces the risk of delamination or cracking occurring. Delamination and cracking undesirably increase the risk that moisture penetrate the casing into the parting line between the casing and lead frame/die paddle.

Advantageously, the incorporation of the aperture does not alter the existing outer geometry of the die paddle. Further advantageously, the at least one aperture allows the moulded casing to extend through the die paddle for improved material flow at the point of moulding the casing, and more robust adhesion of the casing to the die paddle.

According to a third aspect of the invention there is provided a semiconductor assembly comprising:
the die paddle according to the first or second aspects of the invention;
a die coupled to the die paddle;
a connector coupled to the die; and
a casing, which surrounds the die and at least part of the die paddle and the connector, the casing being coupled to the die paddle by a portion of the casing which extends through the at least one aperture of the die paddle between the first and second major faces of the die paddle.

The die maybe a single component or may comprise multiple constituent components. The die is preferably coupled to the die paddle using solder. The die being coupled to the die paddle may otherwise be described as the die being attached to the die paddle. The die may be a silicon chip.

The connector may comprise a clip. The connector may be wirebonded to the die.

The casing may otherwise be described as a capsule or shield. The casing maybe described as encapsulating the die. The casing advantageously reduces the risk of contaminants, such as moisture, penetrating into the semiconductor assembly. The portion of the casing which extends through the at least one aperture of the die paddle may be described as an attachment portion, or anchor, of the casing. The casing preferably extends between both first and second major faces of the die paddle. Described another way, the casing is preferably provided on both the first and second major faces of the die paddle, with a portion of material extending therebetween to at least partially assist in the anchoring of the casing to the die paddle.

The portion of the casing which extends through the at least one aperture of the die paddle may be said to permeate, traverse of fill-up the at least one aperture.

Advantageously, the semiconductor assembly according to the invention incorporates a casing which is more robustly coupled to the die paddle. The semiconductor assembly package is therefore more robust and secure, with the internal components of the semiconductor assembly being better protected by the casing and the casing having a lower risk of delaminating and/or cracking.

The connector may comprise a clip, wherein the clip is coupled to the die.

The clip may comprise one or more legs. The clip may be described as a conductive body by which the semiconductor assembly is connected, or connectable, to an external electrical circuit in use. The clip may be coupled to the die paddle by virtue of being coupled to the die. Described another way, the clip maybe described as being indirectly coupled to the die paddle. The clip is preferably coupled to the die by solder.

Advantageously, the clip provides desirable conductivity.

The casing may be plastic.

The casing may otherwise be described as being manufactured from a polymer. The casing is preferably manufactured using an injection moulding process where an at least partially molten material flows through and around the die paddle, through the at least one aperture, and is then moulded into the desired casing shape. The plastic may be a thermoplastic (e.g. a thermosetting polymer).

The casing may obscure all apertures defined in the coined region of the die paddle.

The casing obscuring all apertures defined in the coined region of the die paddle may otherwise be described as all apertures provided within that first coined region being hidden from view. Described another way, the material of the casing extends over and around the apertures.

Advantageously, the casing arranged in this manner has been found to more robustly couple to the die paddle and provide improved results in use.

According to a fourth aspect of the invention there is provided a method of manufacturing the semiconductor assembly of the third aspect of the invention, comprising:
coupling the die to the die paddle;
coupling the connector to the die; and
moulding the casing at least partly over the die paddle, wherein moulding the casing comprises flowing a material of the casing through the at least one aperture of the die paddle such that the casing is coupled to the die paddle.

Coupling the connector to the die may comprise coupling a clip to the die.

The method may further comprise manufacturing the die paddle, and wherein manufacturing the die paddle comprises defining the at least one aperture by one or more of a laser cutting, etching or stamping process.

The optional and/or preferred features of each aspect of the invention as set out herein are also applicable to any other aspect of the invention where appropriate.

Embodiments of the present invention will now be described, by way of example only, with reference to the accompanying drawings in which:
Figure 1 is a perspective view of a first major face of a die paddle according to an embodiment of the invention;
Figure 2 is a magnified view of a region of interest of the die paddle of Figure 1;
Figures 3a-h schematically illustrate a method of manufacturing a semiconductor assembly incorporating the die paddle of the proceeding Figures;
Figure 4 is a cross-section image, through a semiconductor assembly incorporating the die paddle of the preceding Figures, showing material of a casing extending through an aperture of the die paddle;
Figure 5 is a cross-section image, through a semiconductor assembly incorporating the die paddle of the preceding Figures, showing material of a casing extending partway through a slot of the die paddle;
Figure 6 is a plan view of a first major face of a die paddle according to another embodiment;
Figure 7 is a perspective view of the die paddle of Figure 6;
Figure 8 is a plan view of a first major face of a die paddle, according to another embodiment, shown attached to a surrounding lead frame;
Figure 9 is a plan view of a second major face of the die paddle of Figure 8 attached to the lead frame;
Figure 10 is an X-ray image showing a part-transparent view of a semiconductor assembly including the die paddle of Figures 6 and 7;
Figure 11 is a cross-section view of the Figure 10 die paddle shown about the cross-section indicated in Figure 10; and
Figures 12 and 13 are magnified views of regions of interest of the cross-section view of Figure 9.

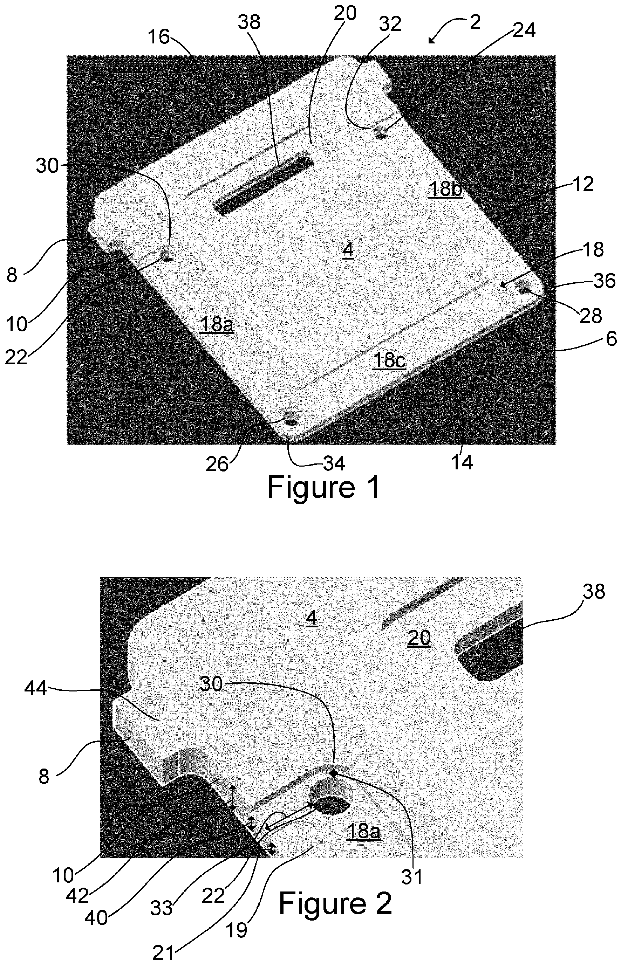

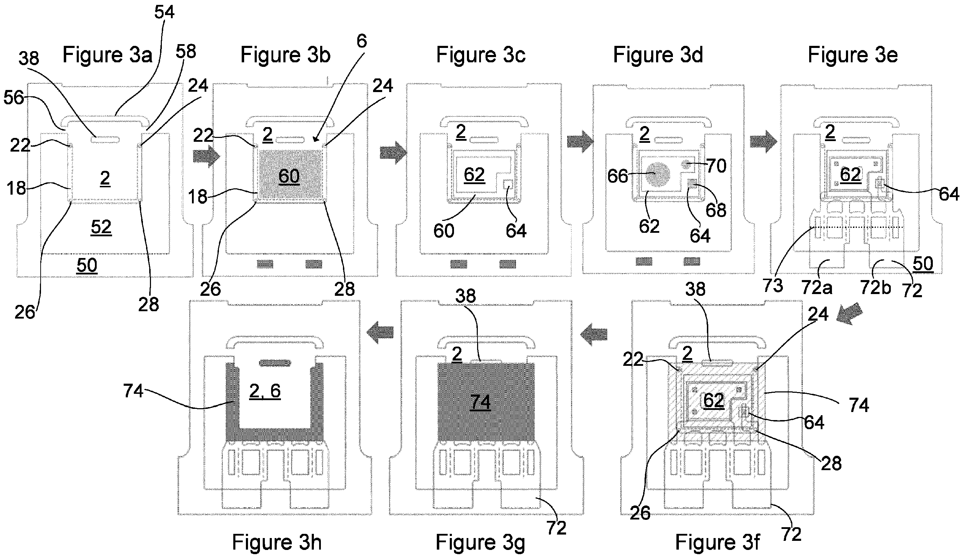

Turning to Figure 1, a perspective view of a die paddle 2 according to an embodiment of the invention is provided. The die paddle 2 is used in the manufacture of semiconductor assemblies, such as transistors, as set out in the process shown in Figures 3a-h (which will be described in detail later in this document).

Returning to Figure 1, in the illustrated embodiment the die paddle 2 is manufactured from copper, but other conductive materials may otherwise be used. The die paddle 2 is a generally plate-like component, and is generally quadrangular. The die paddle 2 forms a base of sorts in the manufacture of a semiconductor assembly, such a transistor.

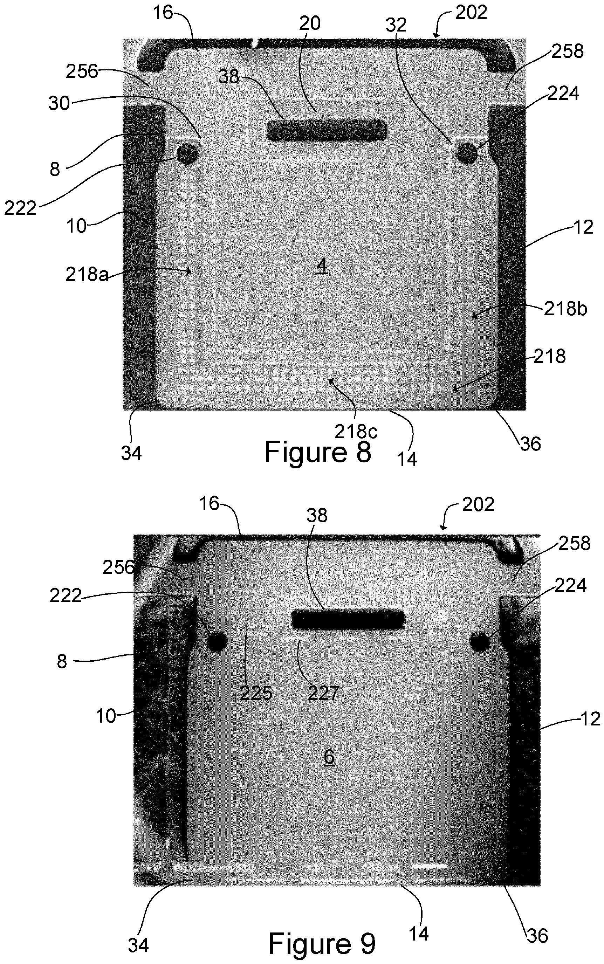

Figure 1 is taken generally from the perspective of a first major face of the die paddle 2, which may otherwise be described as a rear of the die paddle (e.g. a die paddle bottom side view). The second major face 6, generally obscured from view in Figure 1, opposes the first major face 4. The second major face 6 may otherwise be described as a front face of the die paddle 2. The second major face 6 is largely, if not entirely, flat in the illustrated embodiment. In contrast, and as will be described in detail throughout this document, the first major face 4 incorporates various coined regions (e.g. recesses) therein, among other features. Although the second major face 6 may be largely, or entirely, flat, in some embodiments a plurality of indentations may be provided thereon (e.g. see Figure 9). Said indentations aid the locking of a mould compound to the die paddle 2 (i.e. improving adhesion of a casing thereto). The first and second major faces 4, 6 are offset from one another, by what may be described as a thickness of the die paddle 2. As will be appreciated from Figures 1 and 2, the thickness of the die paddle 2 is variable across its extent, owing to the aforementioned coined regions (among other features).

Each of the first and second major faces 4, 6 are defined by an outer perimeter 8 of the die paddle 2. The outer perimeter 8 refers to an outermost edge which extends around the entirety around the die paddle 2. In the illustrated embodiment the outer perimeter 8 of the die paddle 2 is generally defined by first to fourth sides 10, 12, 14, 16, which may be referred to as a plurality of sides. The plurality of sides may be described as defining two pairs of generally opposing sides. For example, the first and second sides 10, 12 generally oppose one another, and the third and fourth sides 14, 16 similarly also generally oppose one another. In the illustrated embodiment the outer perimeter 8, defined by the plurality of sides 10, 12, 14, 16, is generally quadrangular, specifically generally square. However, other shapes of die paddle 2 could alternatively be used in practice.

As shown in Figure 1, the die paddle 2 comprises two coined regions 18, 20. As mentioned above, coined region refers to a region of a reduced thickness relative to the rest of the surrounding material, possibly created by an etching operation, a stamp operation or other material removing process. Coined regions create a variable thickness which is advantageous for the bonding of a casing over, and to, the die paddle 2, as will be described in connection with later Figures and as is shown in Figures 3a-h. Returning to Figure 1, a first coined region 18 extends part way along the first and second sides 10, 12, and extends along an entirety of the third side 14. The first coined region 18 therefore extends along three of the plurality of sides which define the outer perimeter 8 of the die paddle 2. Put another way, the coined region 18 extends around a majority of the outer perimeter 8 of the die paddle 2. The first coined region 18 also extends from the outer perimeter 8 of the die paddle 2 along each of the first, second and third sides 14. Described another way, the coined region 18 extends to, or from, the outer perimeter 8 of the die paddle 2 at least part way along each of the first, second and third sides 10, 12, 14. The first coined region 18 may be described as an external, or peripheral, coined region insofar as it extends at least partly to, or from, the outer perimeter 8 of the die paddle 2. In the illustrated embodiment each of the first to third portions 18a, 18b, 18c of the first coined region 18 extend to, or from, the outer perimeter 8 of the die paddle 2 along their entire extent (e.g. major dimension). The thickness of the die paddle 2 in the coined region 18 is lower than that of the adjacent thickness of the die paddle 2 (e.g. than the surrounding 'non-coined' region[s]). The first coined region 18 may be defined as comprising first, second and third portions 18a, 18b, 18c of the coined region 18. The first and second portions 18a, 18b of the first coined region 18 extend part way along each of the first and second sides 10, 12. The third portion 18c of the coined region 18 extends along an entirety of the third side 14 and also interposes the first and second portions 18a, 18b of the coined region 18. The combination of the first, second and third portions 18a, 18b, 18c of the first coined region 18 therefore defines a continuous recess, which is U-shaped in the illustrated embodiment (but, equally, other shapes could otherwise be used in other embodiments). No coined region extends to the fourth side 16. Put another way, the die paddle 2 has a full thickness along the fourth side 16.

A feature of relevance to the present invention is that of apertures in the coined region 18. In the illustrated embodiment there are a total of four apertures: a first aperture 22, a second aperture 24, a third aperture 26 and a fourth aperture 28. Each of the apertures 22, 24, 26, 28 is provided in a different position at the coined region 18. Each of the apertures 22, 24, 26, 28 extends through the coined region 18, to provide a through-hole locking functionality with a moulded casing which is moulded over the die paddle 2 in a later stage of manufacture of the semiconductor assembly (which, again, will be described in connection with Figures 3a-h). The apertures 22, 24, 26, 28 may be described as openings, or bores.

The first aperture 22 may be described as being provided at a first end of the first portion 18a of the first coined region 18. The third aperture 26 may be described as being provided at a second, opposing end of the first portion 18a of the first coined region 18. The third aperture 26 may also be described as being provided at a first end of the third portion 18c of the first coined region 18. The second aperture 24 may be described as being provided at a first end of the second portion 18b of the first coined region 18. The fourth aperture 28 may be described as being provided at a second, opposing end of the second portion 18b of the first coined region 18. The fourth aperture 28 may also be described as being provided at a second end of the third portion 18c of the first coined region 18, where the second end opposes the first end.

As will be described in more detail in connection with Figure 2, each of the first and second apertures 22, 24 is disposed adjacent internal corners of the die paddle 2. Specifically, owing to the placement of the first coined region 18 relative to the rest of the die paddle 2, each of the first and second apertures 22, 24 are at least partly surrounded by a thicker region (e.g. non-coined region) of the die paddle 2. The inventors have identified that in such regions, when a casing is over moulded over the die paddle 2, such that the first coined region 18 is entirely obscured, these internal corners 30, 32 are stress raisers and the risk of the casing delaminating and/or cracks forming therein is increased at such internal corners. By incorporation of the corresponding apertures 22, 24, through which material of the moulded casing extends (e.g. so that material extends from the first major face 4 to the second major face 2 of the die paddle 2) the adhesion strength of the casing to the die paddle 2 is greatly improved. Accordingly, incorporation of the one or more apertures disposed adjacent an internal corner of the die paddle 2 therefore advantageously provides an improved robustness of semiconductor assembly, with a reduced risk of delamination and/or cracking of the casing. The delamination and cracking issues are partly attributed to the fact that the die paddle 2 is typically manufactured from copper, whereas the surrounding casing is manufactured from a polymer, such as plastic. The coefficients of thermal expansion of the two different materials are different in practice and, as such, delamination and/or cracking may result at boundaries between the die paddle 2 and the casing (due to the different rates of thermal expansion in use). The inventors have also identified that the internal corners 30, 32 are regions where the comparatively faster expanding copper die paddle 2 expands in multiple directions, with respect to the casing, owing to both the coined region 18 and the surrounding material which defines the internal corners 30, 32. The presence of the internal corners 30, 32 is therefore understood to be a particular stress raiser, notwithstanding the different coefficients of thermal expansion of the die paddle 2 and casing materials.

Turning to consider the third and fourth apertures 26, 28, these apertures are disposed adjacent external corners 34, 36 of the die paddle 2, which may be referred to as first and second external corners respectively. The inventors have identified these regions as also being regions susceptible to the delamination and/or cracking of a surrounding casing, again attributed at least in part to the corner location. In particular, at the external corners 34, 36, absolute thermal expansion is the greatest, and stresses are therefore highest, where the geometric centre of the die paddle 2 is taken as a point of zero differential expansion between the materials. Like for the first and second apertures 22, 24, the inventors have found that incorporation of the third and fourth apertures 26, 28, disposed adjacent the external corners 34, 36, gives rise to a reduced risk of delamination and cracking of the surrounding casing, and therefore advantageously provides a more robust semiconductor assembly. The aperture being disposed adjacent the external corner may otherwise be defined as a proximate edge of the aperture being provided within two major dimensions (e.g. within two diameters, for a circular aperture), of the aperture, of the external corner. The aperture being disposed adjacent the external corner may be defined as a geometric centre of the aperture being provided within two major dimensions (e.g. within two diameters, for a circular aperture), of the aperture, of the external corner (e.g. of an apex thereof).

For completeness, in some embodiments apertures may be provided at other positions along the first, second and third portions 18a, 18b of the first coined region 18 (e.g. partway therealong). For example, the die paddle 2 may comprise an array of apertures disposed at the first coined region 18. In some embodiments, the third and fourth apertures 26, 28 may be omitted (i.e. there may be no apertures disposed proximate external corners 34, 36 of the die paddle 2).

Turning briefly to discuss the second coined region 20 of the die paddle 2, the second coined region 20 is a generally loop-shaped coined region insofar as thicker material of the die paddle 2 surrounds the second coined region 20 on all sides. Put another way, the second coined region 20 does not extend from, or to, the perimeter 8 of the die paddle 2. The second coined region 20 may be described as an internal coined region insofar as it is does not extend to the outer perimeter 8 of the die paddle 2. The second coined region 20 surrounds a slot 38 which is also present in a central region of the die paddle 2. In practice, the function of the slot 38 is also to improve the adhesion of the casing to the die paddle 2.

In the illustrated embodiment each of the first to fourth apertures 22, 24, 26, 28 are circular bores. However, other shapes are possible. For example, the apertures could otherwise be slots, fileted squares and so on. Similarly, whilst four apertures are incorporated in the illustrated embodiment, in practice the invention provides benefits even with only one aperture provided proximate an internal corner (e.g. one of the first and second apertures 22, 24) or one of the apertures provided proximate an external corner (e.g. one of the third and fourth apertures 26, 28). However, in practice, desirable results have been obtained with the arrangement of four apertures shown in Figure 1.

The third and fourth apertures 26, 28 are disposed proximate the outer perimeter 8 of the die paddle 2. Described another way, the third and fourth apertures 26, 28 are located close to the outer perimeter 8. An aperture may be considered to be disposed proximate the outer perimeter 8 of the die paddle if a proximate edge of the aperture is within two diameters (or major dimensions of the aperture, if not circular) of the outer perimeter 8. The aperture may be considered to be disposed adjacent the outer perimeter 8 of the die paddle 8 if a geometric centre of the aperture is provided within two major dimensions (e.g. within two diameters, for a circular aperture), of the aperture, of the outer perimeter.

As shown in the illustrated embodiment, each of the first to fourth apertures 22, 24, 26, 28 have a substantially uniform cross-section. In other embodiments, the apertures may have a nonuniform cross section (e.g. they may be stepped). For completeness, a slightly tapered cross-section, such as to facilitate manufacture, is still considered to fall within the definition of a substantially uniform cross-section.

Turning to Figure 2, a magnified view of the first aperture 22 is provided, along with the surrounding features of the die paddle 2.

Figure 2 shows, in more detail, the presence of the first portion 18a of the coined region 18 in that a thickness 40 of said region is lower than a comparative thickness 42 of the non-coined region (e.g. which is a 'full' thickness of the die paddle 2). Figure 2 also illustrates that the first portion 18a of the coined region 18 is not, in itself, entirely flat, and may incorporate one or more further stepped portions or other geometries. One such stepped portion is labelled 19, with a corresponding thickness 21. Thickness 21 is lower than the thickness 40 (and, by association, also lower than thickness 42).

As described in connection with Figure 1, the first aperture 22 (and, indeed, the second aperture not shown in Figure 2) are disposed adjacent internal corners of the Die paddle 2. Specifically, the first aperture 22 is disposed adjacent the first internal corner 30. The internal corner 30 is partly defined by the first coined region 18, particularly the first portion 18a thereof. The presence of the coined region 18 means that the first aperture 22 is at least partly surrounded, on two sides (e.g. quadrants, in this instance), by comparatively thicker material (e.g. 42) of the surrounding, non-coined die paddle 2. The aperture 22 may be said to be surrounded by thicker material around at least 15%, at least 25%, or at least 50% of the perimeter of the aperture 22. The surrounding is with respect to the cross-section of the aperture 22 (e.g. when the aperture 22 is viewed in plan, like that shown in Figure 1). The aperture 22 being disposed adjacent the internal corner 30 may otherwise be defined as a proximate edge of the aperture 22 being provided within one major dimension, of the aperture, of the internal corner. The proximate edge of the aperture 22 may be provided within half of a major dimension, of the aperture, of the internal corner. The distance labelled 31 in Figure 2 indicates the (minimum) distance between a proximate edge of the aperture 22 and the internal corner 30.

A distance labelled 33 indicates the (minimum) distance between a proximate edge of the aperture 22 and the outer perimeter 8 of the die paddle 2. In the illustrated embodiment the distance 33 is approximately 1.5 times the outer diameter of the aperture 22. The aperture 22 may be described as being disposed proximate the outer perimeter 8 of the die paddle 2. The distance 33 is preferably equal to at least the thickness 40 of the coined region 18. For example, if the coined region 18 has a thickness of around 125 microns, the distance 33 is preferably also at least 125 microns.

Also visible in Figure 2 is a projection 44 of the die paddle 2. The projection 44 extends from the first side 10 and corresponds to a position where the die paddle 2 is cut from a surrounding lead frame as part of the manufacturing process. See, for example, branch 56 shown in Figure 3a. The branch 56 may be considered to define part of (one) shoulder of the die paddle 2, the shoulder also being defined by the internal corner 30. The same applies for the branch and internal corner provided on the opposing, second side of the die paddle 2. The non-coined region of the die paddle 2 may therefore be described as being generally T-shaped.

Turning to Figures 3a-h, a method of manufacturing a semiconductor assembly comprising the die paddle 2 is schematically indicated.

Beginning with Figure 3a, the die paddle 2 is shown in a form where it is still connected to a surrounding lead frame 50. The lead frame 50 is effectively a planar plate of conductive material, such as copper, from which the geometry of the die paddle 2 is stamped. As such, as shown in Figure 3a, the closed shapes labelled 52 and 54 are openings in the lead frame 50 which are not full of material (i.e. they are voids). As shown in Figure 3a, the die paddle 2 is only attached to the surrounding lead frame 50 by virtue of branches 56, 58. As will be appreciated by comparing Figure 3a with Figure 2, a first branch 56 goes on to define the projection 44 when the die paddle 2 is extracted from the surrounding lead frame 50. The branches 56, 58 could otherwise be described as attachment points where the die paddle 2 is attached to the lead frame 50. The lead frame 50 may comprise an array of, for example, 20 x 5 die paddles (e.g. for a batch production process).

Figure 3a is taken from the perspective of the second major face 6, which opposes the first major face 4. It will be recalled that the coined region 18 is provided on the first major face 4 (e.g. as shown in Figure 1). Dashed lines are used in Figures 3a-g to indicate the coined region 18 being obscured from view from the perspective of the second major face 6. The coined region 18 (e.g. coining) may be said to be located on the underside of the die paddle 2 relative to what is shown in Figures 3a-g.

For completeness, all of the features of the die paddle 2 are not labelled in Figures 3a-3f for brevity, but the first coined region 18 is shown indicated by a dashed line and first to fourth apertures 22, 24, 26, 28, disposed thereon, are also labelled.

Turning to Figure 3b, a subsequent step of the manufacture process is schematically indicated. In the step shown in Figure 3b, solder 60 is printed or dispensed onto the die paddle 2. The solder 60 may be said to be printed or dispensed onto the second major face 6 which opposes the (first major) face of the die paddle 2 in which the first coined region 18 is provided. Put another way, the solder 60 may be said to be printed or dispensed onto the non-coined face of the die paddle 2. As will be appreciated from Figure 3b, the solder 60 is provided within the bounds of the coined region 18, albeit on a different side of the die paddle 2. The solder 60 does not encroach onto any of the first to fourth apertures 22, 24, 26, 28.

In a subsequent step shown in Figure 3c, first and second components 62, 64 of a die are attached to the die paddle 2 by the solder 60. This step may therefore be described as the die being coupled to the die paddle 2.

In the subsequent step shown in Figure 3d, solder is dispensed or printed onto the die, specifically onto first and second components 62, 64. The constituent soldering regions are labelled 66, 68, 70 respectively.

In the subsequent manufacture step shown in Figure 3e, a clip 72 is coupled to the die paddle 2 by virtue of being connected to the die and solder regions 66, 68, 70 thereon. The clip 72 comprises a plurality of legs which may otherwise be described as connectors for connecting the die components 62, 64 in an electrical circuit (e.g. for connecting the semiconductor assembly in an electrical circuit). The clip 72 is initially attached to a larger strip of copper, in a similar manner to the lead frame 50, but is detached from said strip in advance of being attached to the die paddle 2 in the illustrated embodiment. The clip 72 may be said to be attached to a top of the die. The bottom of the die may be said to be attached to the die paddle 2. The clip 72 is thus vertically offset from the die paddle 2 by a thickness of the die, which forms a gap. It is through the gap that material of the casing can flow to reach the third and fourth apertures 26, 28 (e.g. see Figures 3a and 3b). Put another way, the clip 72 does not 'seal' the third and fourth apertures 26, 28 from the casing material. The material flows under the clip 72 into the apertures of the die paddle 2.

The clip 72 is also attached to the surrounding leadframe 50 at points 72a, 72b. In a later step of the process (i.e. after Figure 3h), the clip 72 is cut across line 73 to isolate the clip 72 from the leadframe 50 and define a plurality of legs (e.g. leads) of the clip 72.

For completeness, although the illustrated embodiment comprises the clip 72, the clip 72 is not an essential feature of the invention. In other embodiments, wirebonding may instead be used to couple a connector to the die. The connector may comprise one or more external leads. However, using the clip is preferable because the clip has desirable conductivity characteristics.

Turning to the step shown in Figure 3f, in Figure 3fa a casing 74 is moulded onto the subassembly shown in Figure 3e. Put another way, the casing 74 is overmoulded to the die paddle 2, die including components 62, 64, and clip 72. Importantly, the casing 74 does not entirely surround all of these components, but should surround at least the die components 62, 64 (which may simply be referred to as a die). The casing 74 may therefore be said to surround the die and at least part of the die paddle 2 and the clip 72. The extent to which the casing 74 covers the subassembly is indicated by the hatched markings shown in Figure 3f. Also, the casing 74 is shown in a partially transparent view so as to aid the understanding of the location of the casing 74. The casing 74 is typically a polymer, such as plastic. The purpose of the casing 74 is to protect the die from moisture ingress and impacts. As will be appreciated from Figure 3e, before the casing 74 is applied, the first coined region 18 of the die paddle 2, and the first to fourth apertures 22, 24, 26, 28 provided thereon, are still exposed.

The casing 74 is overmoulded to the die paddle 2 by injection moulding a casing material which is able to flow. An example of such a material is a polymer, such as plastic. The material flows through a mould, not shown in Figure 3f, which defines the shape of the casing 74 once the material has set (e.g. hardened, or solidified). This will be described in connection with Figures 3g and 3h. Returning to Figure 3f, Figure 3f indicates how each of the first to fourth apertures 22, 24, 26, 28 are covered as part of the moulding of the casing 74. Put another way, the casing 74 entirely obscures these apertures 22, 24, 26, 28 in the final semiconductor assembly. Also, and as described in connection with earlier figures, advantageously in connection with the invention the apertures 22, 24, 26, 28 provide a path for the casing material to extend entirely through, from the first major face 4 of the die paddle 2 to the opposing second major face 6. As such, each of the apertures 22, 24, 26, 28 defines a through-hole locking feature through which material can extend to more robustly couple the casing 74 to the die paddle 2. Again, as described in connection with earlier figures, this reduces the risk of the casing 74 delaminating and/or cracking, particularly in high risk regions such as the internal corners of the die paddle 2 and the external corners of the same.

Also of mention in connection with Figure 3f, the slot 38 is only partly covered by the casing 74. As such, the casing 74 does not entirely obscure the slot 38. Instead, the casing 74 only extends through part of the slot 38. Described another way, the slot 38 is still visible even once the casing 74 has been moulded.

Turning to Figure 3g, Figure 3g can be considered to be an alternative view to that shown in Figure 3f. In Figure 3g the casing 74 is shown as a solid body, as opposed to the cross hatched indication in Figure 3f. Figure 3g therefore demonstrates how the casing 74 obscures the first four apertures 22, 24, 26, 28 (not visible in Figure 3g but shown in Figure 3f) but part of the slot 38 remains visible (e.g. exposed). Similarly, at least part of the clip 72 also remains visible despite the application of the casing 74, with the clip 72 being used to attach the semiconductor assembly to an electrical circuit, for example.

Turning finally to Figure 3h, although indicated as a subsequent manufacturing step Figure 3h can otherwise be described as simply being an alternative view to the images shown in Figure 3g (and, by extension, Figure 3f). Figure 3g shows the conductor assembly from the general perspective of the second major face 6 of the die paddle 2. In contrast, Figure 3h shows the semiconductor assembly from the perspective of the first major face 4 of the die paddle 2 (e.g. the same face which incorporates the coined region 18). Figure 3h again indicates that part of the slot 38 remains visible despite the presence of the casing 74, and also a significant proportion of the second major face 6 remains unobscured by the casing 74 (providing an exposed copper region for heat extraction in use). Instead, the casing 74 extends part way around three sides of the perimeter of the die paddle 2 in a manner which largely corresponds to the first coined region.

In a subsequent step of manufacture, which is not shown in Figures 3a-h, the die paddle 2, and other components of the semiconductor assembly which are coupled to the die paddle 2, is detached from the surrounding lead frame (50 in Figure 3a) by cutting the branches 56, 58 shown in Figure 3a. During the cutting process, leads, of the clip 72, are also cut and formed. Assembly of the semiconductor assembly is therefore complete.

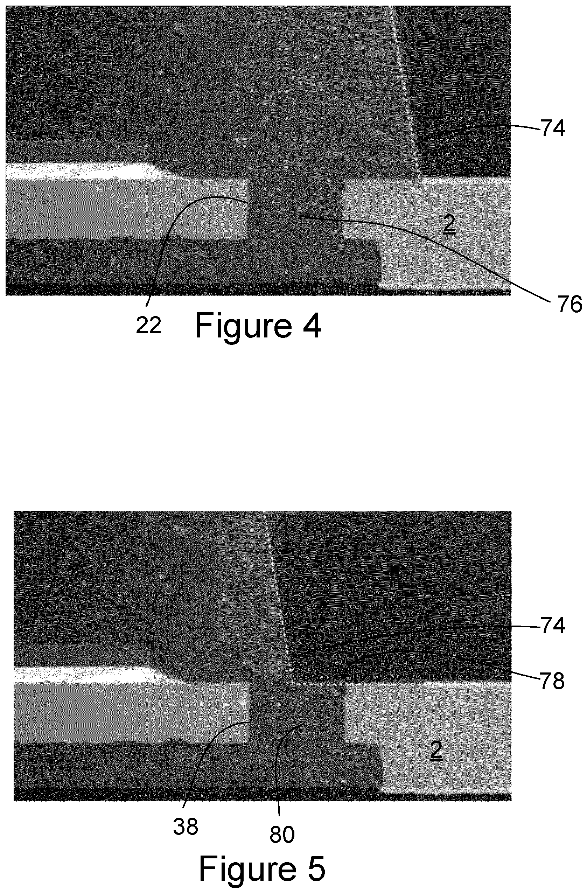

Turning to Figure 4, a cross-section view of part of the semiconductor assembly is provided. The Figure 4 view shows the die paddle 2, the casing 74 and the first aperture 22 extending through the die paddle 2. Figure 4 demonstrates that the casing 74 extends entirely through the first aperture 22, specifically by virtue of a portion 76 of material of the casing 74. Owing to the location of the casing 74 as shown in Figure 4, the first aperture 22 is entirely obscured by the casing 74. Described another way, the first aperture 22 is not visible externally once the casing 74 has been overmoulded. This is in contrast to Figure 5, which is a cross-section through the semiconductor assembly but specifically through the slot 38 of the die paddle 2. It will be appreciated from Figure 5 that the slot 38 is still externally visible, at least at the exposed region 78. For completeness, a portion of material 80 of the casing 74 still extends through the slot 38, but, as mentioned above, but the slot 38 is not entirely obscured by the casing 74.

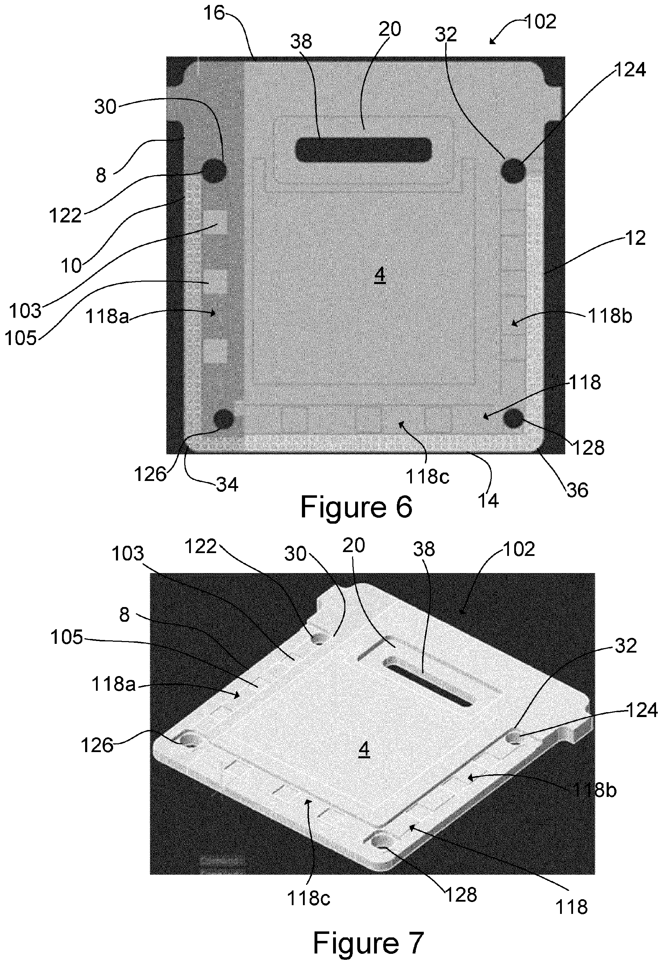

Turning to Figure 6, a plan view of a die paddle 102 according to another embodiment is provided. The die paddle 102 shares many features in common with the die paddle 2 shown in the preceding Figures. As such, only the differences will be described here in detail, the different features being incremented by 100 relative to those of the previous Figures.

The primary differences between the die paddle 102 and die paddle 2 relate to a first coined region 118 and associated position of first to fourth apertures 122, 124, 126, 128. Beginning first with the first coined region 118, like in the earlier embodiment the coined region 118 comprises first and second portions 118a, 118b which extend part way along first and second sides 10, 12 of the die paddle 102. A third portion 118c of the first coined region 118 extends across an entirety of a third side 34 of the die paddle 102, and interposes the first and second portions 118a, 118b. Like in the earlier embodiment, four apertures 122, 124, 126, 128 are provided, and all are disposed in the coined region 118. Beginning first with the first aperture 122, as in the earlier embodiment the first aperture 122 is provided in the first portion 118a of the coined region 118. The first aperture 122 is also disposed adjacent, and partly surrounded by, an internal corner 30 defined by the first coined region 118a. Unlike the earlier embodiment, the first aperture 122 is disposed closer to the internal corner 30 and, in some embodiments, may even be collinear with the internal corner 30. That is to say, part of the edge of the aperture 122 may also define part of the internal corner 30. The above description, in respect of the first aperture 122, also applies to the second aperture 124 and the corresponding internal corner 32 (which the second aperture 124 is disposed adjacent to, and is at least partly surrounded by). The first and second apertures 124, 126 are also concentric with the adjacent first and second internal corners 30, 32.

Turning to the third and fourth apertures 126, 128, these apertures are also disposed in the coined region 118, and across each of the first, second and third portions 118a, 118b, 118c thereof. Third and fourth apertures 126, 128 are also disposed adjacent to external corners 34, 36 of the die paddle 102. The third and fourth apertures 126, 128 are also concentric with the (filleted) adjacent external corners 34, 36.

A further subtle difference between the die paddle 102 and die paddle 2 is the presence of a plurality of pads provided on the first coined region 118. Two examples of such pads are labelled 103, 105. The pads 103, 105 (and others) are regions which have a different coin depth. These features advantageously define additional anchoring points for the casing material to grip on.

Turning to Figure 7, a perspective view of the die paddle 102 as shown in Figure 6 is provided. The perspective view of Figure 7 shows the pads 103, 105 provided in the coined region 118, more clearly, and shows the layout of the first to fourth apertures 122, 124, 126, 128 from a different angle.

Turning to Figure 8, a plan view of a die paddle 202 according to another embodiment is provided. The die paddle 202 shares many features in common with the die paddles 2, 102 shown in the previous embodiments, and only the differences will be described in detail. Different features are incremented by 100 relative to the die paddle 102, and 200 relative to the die paddle 2.

Of note, the die paddle 202 shown in Figure 8 (and 9) is still attached to a surrounding lead frame as can be observed by the presence of branches 256, 258. The view shown in Figure 8 corresponds to that of the first major face 4.

Like the preceding embodiments, the die paddle 202 comprises a first coined region 218 which comprises first, second and third portions 218a, 218b, 218c respectively. The first and second portions 218a, 218b extend only part way along respective first and second sides 10, 12 of the die paddle 202. The third portion 218c extends entirely along the third side 14 of the die paddle 202 and interposes the first and second portions 218a, 218b.

A first primary difference of the die paddle 202 relative to the earlier embodiments is that coined region 218 comprises only two apertures: a first aperture 222 and a second aperture 224. Described another way, there is no aperture provided in place of the third and fourth apertures of the earlier embodiments, which were provided proximate first and second external corners 34, 36. For the die paddle 202, a third portion 218c of the coined region 218 is free of any apertures. The inventors have found that even in the absence of third and fourth apertures, the presence of the first and second apertures 222, 224 alone reduces delamination and cracking of a casing when overmoulded over the die paddle 202. For the avoidance of doubt, the first and second apertures 222, 224 of the die paddle 202 provide the same functionality as those of the first and second apertures of the earlier embodiments.

As mentioned above, the die paddle 202 shares many features in common with the earlier embodiments, including the presence of the slot 38.

Turning to Figure 9, a plan view of the die paddle 202 of Figure 8 is provided from the perspective of the second major face 6. As will be appreciated from Figure 9, the majority of the second major face 6 is flat and has no coined region. However, given that the first and second apertures 222, 224 extend through an entirety of the die paddle 202, the first and second apertures 222, 224 are still visible in Figure 9 (i.e. from the perspective of the second major face 6). The slot 38, which also extends through an entirety of the die paddle 202, is also shown. The second major face 6 comprises regions of small local coining (two of which are labelled 225, 227). These features improve the adhesion of mould material, which forms the casing, to the die paddle 202.

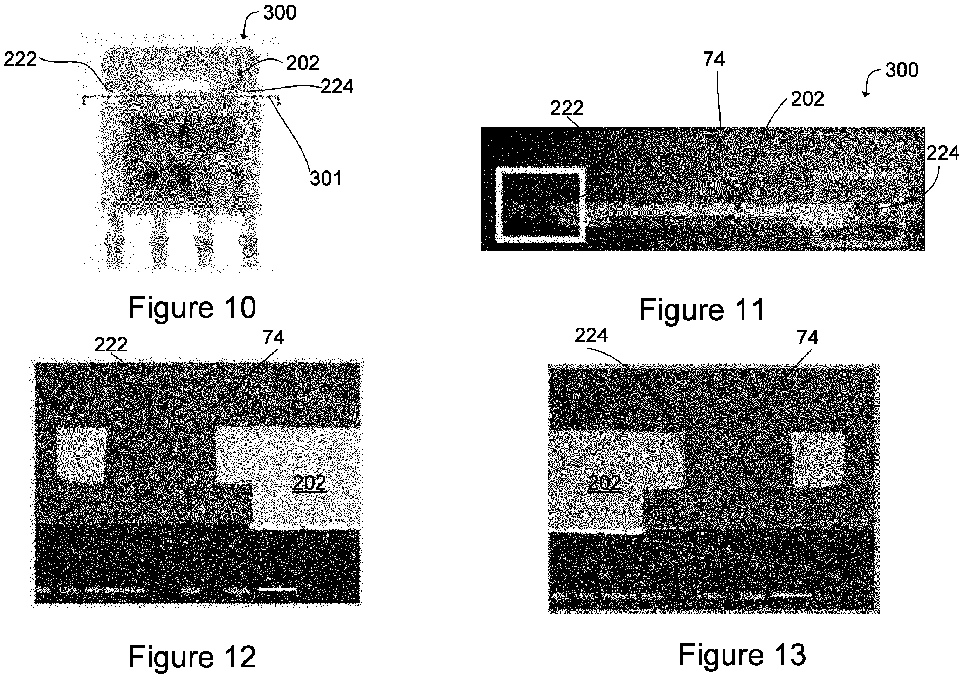

Turning to Figure 10, an X-ray image of a plan view of a semiconductor assembly 300 comprising the die paddle 202 of Figures 8 and 9 is provided. Also marked on Figure 10 is a cross-section line 301, which corresponds to the cross-section view shown in Figure 11.

Turning to Figure 11, as mentioned Figure 11 is a cross-section view through the semiconductor assembly 300 about the cross-section line 301. Figure 11 therefore shows the die paddle 202, the overmoulded casing 74 and first and second apertures 222, 224 through the die paddle 202. As described in connection with earlier embodiments, a portion of the casing 74 extends entirely through the first and second apertures 222, 224 to more robustly couple the casing 74 to the die paddle 202. Similarly, the presence of the casing 74 entirely obscures both of the first and second apertures 222, 224.

For completeness, Figures 12 and 13 are magnified views showing regions of the first and second apertures 222, 224 respectively. Each of Figures 12 and 13 therefore shows part of the die paddle 202, the surrounding casing 74 and material extending entirely through, and obscuring, first and second apertures 222, 224 respectively.

For all of the embodiments described throughout this application, one or more of the apertures may be circular in shape. Alternatively, the apertures may be a non-circular shape such as quadrangular (e.g. square or rectangular), optionally with filleted edges (e.g. having the form of a slot). All of the apertures may share the same geometry, or they may be a mixture of different geometries. Embodiments of the invention may comprise plurality of apertures (e.g. two or four or more) or may comprise a single aperture. The apertures may have a substantially uniform cross section (e.g. circular bore) or have a non-substantially uniform cross section (e.g. be stepped in geometry).

Although the embodiments described herein have comprised only a single slot, in some embodiments the die paddle may comprise a plurality of slots. Similarly, although the embodiments illustrated herein comprise a first coined region which comprises first, second and third portions, other arrangements of coined region are otherwise possible. For example, in some embodiments the third portion may be omitted and only first and second portions, which each extend only part way along respective opposing first and second sides, being provided. Similarly, a coined region may extend around an entire outer perimeter of the die paddle.

The casing may otherwise be described as a cover or shield. The casing may be described as encapsulating one or more of the constituent components of the semiconductor assembly.

One or more of the apertures, where circular, may have a diameter of around 250 microns. The apertures, where circular, may have a diameter of anywhere between 100 to 1000 microns. The apertures, where circular, preferably have a diameter which is at least equal to a thickness of the die paddle. The thickness of the die paddle may be, for example, around 200 µm. The thickness of the apertures preferably corresponds to a thickness of the die paddle in that region. A minimum size of the apertures is driven by manufacturability. A maximum size of the apertures is driven by a desire to retain as much area on the die paddle as possible. In one or more of the illustrated embodiments, a proximate edge of the aperture may be vertically offset from a centre line of the slot by around 100 microns.

Incorporation of the one or more apertures provides improved package strength, reduced delamination and reduced package cracking. The one or more apertures may be described as defining a conduit of sorts through which moulded casing material can flow, so as to effectively adjoin a casing on the first and second major faces of the die paddle.

Advantageously, the at least one aperture means that larger internal die pads can be incorporated. The mould compound has to lock to the (copper, in some embodiments) die paddle. A large, open area of die paddle thus provides a larger contact area, and good locking capability. However, the size of die that can be used is then limited. It is desirable to use the largest die possible, but the uncovered area of paddle is then reduced as a result. By incorporating the apertures of the invention, locking of the mould compound is improved, so the uncovered area of the die paddle can also be reduced, so the size of the die can be increased.

The at least one aperture being at least partially surround by the internal corner may otherwise be described as two adjacent sides of the die paddle, around the aperture, being comparatively thicker, non-coined material. The at least one aperture may be described as being nested within an internal corner of the die paddle, and optionally nested within an internal corner of the coined region.

The semiconductor assembly is preferably a transistor. The semiconductor assembly could otherwise be a diode, thyristor, IGBT.

Throughout this document, a major dimension of a circular aperture is the diameter.

Throughout this document, any aperture is preferably located concentrically with an adjacent corner where the adjacent corner is filleted.

## Claims

1. A die paddle for a semiconductor assembly, comprising:
first and second major faces offset from another by a thickness of the die paddle, and being at least partly defined by an outer perimeter of the die paddle;
a coined region recessed into at least one of the first and second major faces, the coined region extending from, and at least partway around, the outer perimeter of the die paddle; and
at least one aperture, which extends through the coined region, for receipt of material therein; wherein
the at least one aperture is disposed adjacent, and at least partially surrounded by, an internal corner of the die paddle, the internal corner being at least partly defined by the coined region.

2. The die paddle according to claim 1, wherein the at least one aperture is a circular bore.

3. The die paddle according to claims 1 or 2, wherein the at least one aperture comprises a plurality of apertures.

4. The die paddle according to any preceding claim, wherein the at least one aperture is disposed proximate the outer perimeter of the die paddle.

5. The die paddle according to any preceding claim, wherein the outer perimeter of the die paddle is defined by a plurality of sides.

6. The die paddle according to claim 5, wherein the coined region extends only partway along two of the plurality of sides.

7. The die paddle according to claim 6, wherein first and second portions of the coined region, disposed along each of the two of the plurality of sides, at least partly define a respective internal corner.

8. The die paddle according to claim 7, wherein an aperture is disposed adjacent each of the two internal corners defined by the first and second portions of the coined region.

9. The die paddle according to any one of claims 5 to 8, wherein a third portion of the coined region extends along an entirety of at least one of the plurality of sides.

10. The die paddle according to claims 7 and 9, wherein the third portion of the coined region interposes the first and second portions of the coined region.

11. The die paddle according to any preceding claim, wherein the at least one aperture has a substantially uniform cross-section.

12. The die paddle according to any preceding claim, further comprising at least one aperture, disposed proximate an external corner of the die paddle, in the coined region.

13. The die paddle according to claim 12, wherein an aperture is disposed proximate each of a respective two external corners.

14. The die paddle according to claims 10 and 13, wherein the apertures disposed proximate each of the respective two external corners are disposed proximate ends of the third portion of the coined region.

15. The die paddle according to any preceding claim, wherein the internal and/or external corner is filleted, and wherein the adjacent aperture is concentric with the internal and/or external corner.

16. A die paddle for a semiconductor assembly, comprising:
first and second major faces offset from another by a thickness of the die paddle, and being at least partly defined by an outer perimeter of the die paddle;
a coined region recessed into at least one of the first and second major faces, the coined region extending from, and at least partway around, the outer perimeter of the die paddle; and
at least one aperture, which extends through the coined region, for receipt of material therein; wherein
the at least one aperture is disposed adjacent an external corner of the die paddle.

17. A semiconductor assembly comprising:
the die paddle according to any preceding claim;
a die coupled to the die paddle;
a connector coupled to the die; and
a casing, which surrounds the die and at least part of the die paddle and the connector, the casing being coupled to the die paddle by a portion of the casing which extends through the at least one aperture of the die paddle between the first and second major faces of the die paddle.

18. The semiconductor assembly according to claim 17, wherein the connector comprises a clip, wherein the clip is coupled to the die.

19. The semiconductor assembly according to claims 17 or 18, wherein the casing is plastic.

20. The semiconductor assembly according to any one of claims 17 to 19, wherein the casing obscures all apertures defined in the coined region of the die paddle.

21. A method of manufacturing the semiconductor assembly of claims 17 to 20, comprising:
coupling the die to the die paddle;
coupling the connector to the die; and
moulding the casing at least partly over the die paddle, wherein moulding the casing comprises flowing a material of the casing through the at least one aperture of the die paddle such that the casing is coupled to the die paddle.

22. The method according to claim 21, wherein coupling the connector to the die comprises coupling a clip to the die.

23. The method according to claims 21 or 22, wherein the method further comprises manufacturing the die paddle, and wherein manufacturing the die paddle comprises defining the at least one aperture by one or more of a laser cutting, etching or stamping process.
